Europäisches Patentamt

European Patent Office

Office européen des brevets

(11) Numéro de publication: **0 399 872**
**A1**

## (12) DEMANDE DE BREVET EUROPEEN

(21) Numéro de dépôt: **90401274.7**

(22) Date de dépôt: **15.05.90**

(51) Int. Cl.5: **C04B 35/00, H01L 39/14, H01L 39/24**

(30) Priorité: **23.05.89 FR 8906700**

(43) Date de publication de la demande:
**28.11.90 Bulletin 90/48**

(84) Etats contractants désignés:
**AT BE CH DE DK ES FR GB GR IT LI LU NL SE**

(71) Demandeur: **RHONE-POULENC CHIMIE**
**25, quai Paul Doumer**
**F-92408 Courbevoie Cédex(FR)**

(72) Inventeur: **Bonnet, Jean-Pierre**
**Rue Daureau**
**F-33360 Carignan de Bordeaux(FR)**
Inventeur: **Heintz, Jean-Marc**
**Résidence Crespy II, Bâtiment 3A**
**F-33400 Talence(FR)**

(74) Mandataire: **Dubruc, Philippe et al**
**RHONE-POULENC CHIMIE Service Brevets**
**Chimie 25, quai Paul-Doumer**
**F-92408 Courbevoie Cédex(FR)**

(54) **Matériau céramique supraconducteur, composition précurseur de ce matériau et procédé de préparation.**

(57) L'invention concerne un matériau céramique supraconducteur de formule :
$LnBa_{2-x} Cu_{3-x} O_{7-7/3x-\delta}$
dans laquelle :
$0 \leq x \leq 0,5$
$0 \leq \delta \leq 0,5$
Ln est un lanthanide ou l'yttrium.
de densité d'au moins 5,90 et présentant une résistance nulle à une température d'au plus 92 ± 1 K.

Ce matériau est obtenu par frittage d'un mélange à base de $BaCuO_2$, $Ln_2BaCuO_5$ et $CuO$ sous oxygène humide.

EP 0 399 872 A1

# MATERIAU CERAMIQUE SUPRACONDUCTEUR, COMPOSITION PRECURSEUR DE CE MATERIAU ET PRO-CEDE DE PREPARATION

La présente invention concerne un matériau céramique supraconducteur et son procédé de préparation. Elle concerne aussi une composition précurseur de ce matériau.

La préparation de matériaux supraconducteurs du type $YBa_2 Cu_3 O_{7-y}$ est bien connue. Toutefois, un problème important se pose qui est celui de l'obtention d'un produit présentant une densité la plus élevée possible tout en conservant des propriétés électriques et magnétiques satisfaisantes. Il apparaît en effet difficile de réunir ces deux conditions.

L'objet de l'invention est donc l'élaboration d'un produit de haute densité (au moins 80 % de la densité théorique) et à bonnes propriétés supraconductrices.

Dans ce but, et selon une première variante de l'invention, le matériau céramique supraconducteur répond à la formule

$Ln Ba_{2-x} Cu_{3-x} O_{7-7/3x-\delta}$

dans laquelle

$0,5 \leq 1,2$

$0 \leq \delta \leq 0,5$

Ln représentant au moins un élément choisi parmi les lanthanides et l'yttrium.

Selon une seconde variante le matériau céramique supraconducteur de l'invention répond à la formule

$Ln Ba_{2-x} Cu_{3-x} O_{7-7/3x-\delta}$

dans laquelle

$0 \leq x < 0,5$

$0 \leq \delta \leq 0,5$

Ln étant défini tel que précédemment.

Il présente une densité d'au moins 5,90 et une résistance nulle à une température d'au plus $92 \pm 1$ K.

Par ailleurs, le procédé de préparation du matériau de l'invention est caractérisé en ce qu'il comprend un frittage d'un mélange de phases ou de compositions de nature et dans les proportions suivantes :

$n Ba Cu O_2$

$1 Ln_2 Ba Cu O_5$

$2 Cu O$

avec comme condition $0,6 \leq n \leq 3$

Ln étant tel que défini précédemment.

Enfin, l'invention concerne un précurseur de matériau céramique caractérisée en ce qu'il est à base des phases ou compositions suivantes et dans les proportions indiquées :

$m Ba Cu O_2$

$1 Ln Ba Cu O_5$

$2 Cu O$

avec comme condition $0,6 \leq m \leq 3$

Ln étant défini comme ci-dessus.

D'autres caractéristiques et avantages de l'invention apparaîtront plus clairement à la lecture de la description qui va suivre.

En ce qui concerne le matériau celui-ci peut se présenter selon deux variantes.

Dans le cadre de la première variante le matériau répond à la formule

$Ln Ba_{2-x} Cu_{3-x} O_{7-7/3x-\delta}$

dans laquelle

$0,5 \leq x \leq 1,2$

$0 \leq \delta \leq 0,5$

Ln est tel que précédemment défini. En particulier Ln peut être choisi parmi le lanthane, le samarium et le dysprosium. Selon un mode de réalisation plus particulier, Ln est l'yttrium. Il est entendu que dans le cadre de la présente invention, Ln peut désigner une combinaison de deux ou plus des éléments précités.

Dans le cadre de cette variante on peut citer plus particulièrement les produits pour lesquels x est compris entre 0,5 et 1 et notamment x égal à 1.

La densité du matériau selon cette première variante et notamment dans le cas où Ln est l'yttrium est d'au moins 5, c'est à dire au moins 81 % de la densité théorique. Cette densité peut plus particulièrement être d'au moins 5,9 et notamment égale ou supérieure à 6,10 (98 % de la densité théorique).

Par ailleurs, une autre caractéristique du matériau selon cette première variante de l'invention et notamment dans le cas où Ln est l'yttrium est qu'il présente une résistance nulle à une température d'au

2

plus 92 ± 3 K.

En ce qui concerne le matériau selon la seconde variante de l'invention celui se caractérise par sa formule

$$Ln\ Ba_{2-x}\ Cu_{3-x}\ O_{7-7/3x-\delta}$$

dans laquelle

$$0 \le x \le 0,5$$

$$0 \le \delta \le 0,5$$

Ln étant tel que défini ci-dessus et plus particulièrement l'yttrium; par sa densité qui est d'au moins 5,90 et par le fait qu'il présente 10 une résistance nulle à une température d'au plus 92 ± 1 K.

En ce qui concerne sa structure et pour les deux variantes le matériau de l'invention se présente sous forme de grains sensiblement sphériques. La taille des grains est généralement comprise entre 1 et 15 $\mu$m et plus particulièrement entre 2 et 5 $\mu$m notamment pour les produits de densité les plus élevées et ceux selon la seconde variante.

Les grains sont généralement en contact direct c'est-à-dire qu'il n'y a généralement pas de phases intergranulaires aux joints linéaires entre grains.

A la surface du matériau, les grains présentent une très forte tendance à s'orienter de telle sorte que les plans 0,0,1 soient perpendiculaires à cette surface.

Pour les valeurs de x comprises entre 1 et 1,2, la désorientation des grains est inférieure à 10° C.

Comme propriété particulière du matériau de l'invention notamment des produits à densité élevée c'est à dire au moins 5,90, on peut mentionner une grande stabilité de composition lors des traitements thermiques postérieurs au frittage. En effet, le matériau est peu réoxydable. C'est ainsi que sous $O_2$ pendant 48 heures à 550° C sa masse n'augmente pas plus de 2‰.

Le procédé de préparation du matériau de l'invention va maintenant être décrit plus précisément.

L'une des caractéristiques principale du procédé de l'invention réside dans la nature du produit de départ.

Comme on l'a vu plus haut on part d'un mélange constitué par des phases ou compositions déterminées et dans des proportions fixées à savoir

$$n\ Ba\ Cu\ O_2,\ 1\ Ln_2\ Ba\ Cu\ O_5,\ 2\ Cu\ O$$

avec comme condition $0,6 \le n \le 3$

Ln étant tel que défini plus haut et notamment l'yttrium.

Ces phases ou compositions se préparent d'une manière connue en soi.

Par exemple la phase Ba Cu $O_2$ s'obtient en traitant sous oxygène un mélange stoechiométrique Ba $CO_3$, CuO à 900° C pendant 15 quelques heures puis en broyant et retraitant thermiquement le produit obtenu.

Pour la composition $Ln_2$ Ba Cu $O_5$ et notamment dans le cas de l'yttrium, on part d'un mélange stoechiométrique Ba $CO_3$, CuO, $Ln_2$ $O_3$ que l'on chauffe sous air ou sous oxygène à 850-950° C pendant quelques heures.

Pour CuO enfin, on utilise un produit commercial.

Les phases ou compositions de départ ou compositions sont mélangées et broyées. La valeur de n est choisie en fonction du type de produit que l'on cherche à préparer. Pour les produits pour lesquels x est compris entre 0,5 et 1,2, n est compris entre 2 et 0,6. Le mélange est généralement pastillé sous pression.

Le procédé peut être conduit à l'air. C'est le cas notamment pour la préparation de produits à densité les moins élevées.

Toutefois et en particulier, pour les produits à densité plus élevée par exemple au moins 5,90, il est préférable d'opérer sous oxygène.

Selon un mode de réalisation particulier, on conduit le procédé sous atmosphère d'oxygène humide c'est à dire d'oxygène et d'eau, la pression partielle d'eau variant généralement entre 1/100 et 5/100 d'atmosphère.

L'oxygène doit de préférence être substantiellement pur, il doit être notamment exempt de $CO_2$.

Le frittage s'effectue en principe à une température comprise entre 930 et 990° C de préférence entre 970 et 980° C pendant une durée qui est de l'ordre de l'heure habituellement.

Avant le frittage proprement dit, il est avantageux de faire subir un traitement thermique au mélange. Ce traitement se fait à une température comprise entre 700 et 830° C. Sa durée peut être comprise entre 1 et 15 heures.

Après le frittage, le refroidissement se fait généralement par palier d'une manière connue en soi.

Toutefois, on notera qu'il est possible, surtout pour les produits les plus denses, de réaliser en dessous de 800° C environ un refroidissement rapide du produit lors d'une dernière étape du procédé. On entend ici par rapide, un temps de quelques dizaines de minutes.

Comme on l'a vu plus haut, l'invention concerne aussi un précurseur de matériau céramique. Ce précurseur est à base du mélange m Ba Cu $O_2$, 1 $Ln_2$ Ba Cu $O_5$ et 2 Cu O avec comme condition que 0,6 ≤ m ≤ 3. Il peut se présenter sous forme de poudre. Il peut aussi se présenter sous forme pressée.

Des exemples concrets mais non limitatifs vont maintenant être donnés ;

## Exemple 1

On prépare le mélange 1 Ba Cu $O_2$, $Y_2$ Ba Cu $O_5$ et 2 Cu O. Après pesées, le mélange est broyé et pastillé sous une pression de 2 T/cm². Les pastilles ainsi obtenues ont un diamètre de 8 mm et une épaisseur de 2 mm.

On fritte les pastilles sous oxygène humide c'est-à-dire ici de l'oxygène saturé par barbotage dans de l'eau à température ambiante.(pression partielle d'eau 3,5/100 d'atmosphère)

Le cycle thermique est le suivant :

| température | temps (en heure) |
|---|---|
| 800°C | 1 |
| 900°C | 1/2 |
| 974°C (frittage) | 1 |
| 900°C | 2 |
| 800°C | 1 |

On laisse le produit se refroidir.

On obtient un produit de formule Y Ba $Cu_2O_{4,66-\delta}$ de densité 6,16 de taille de grains sphériques comprise entre 3 et 5 $\mu$m et présentant une résistance nulle au-dessous de ou à 90 K.

Pendant 48 heures à 550°C sous $O_2$ sa masse augmente de 1,6 ‰.

## Exemple 2

On procède comme dans l'exemple 1 mais en partant du mélange 1,4 Ba Cu $O_2$, $Y_2$ Ba Cu $O_5$, 2 Cu O et selon le cycle thermique suivant :

| température | temps (en heure) |
|---|---|
| 900°C | 1 |
| 966°C (frittage) | 1 |
| 900°C | 2 |
| 800°C | 1 |

On refroidit comme dans l'exemple 1.

On obtient un produit de formule Y $Ba_{1,2}$ $Cu_{2,2}$ $O_{5,13-\delta}$ de densité 5,30 et présentant une résistance nulle au-dessous de ou à 93,5 K.

## Exemple 3

On procède comme dans l'exemple 1 mais en partant du mélange 3 Ba Cu $O_2$, $Y_2$ Ba Cu $O_5$, 2 Cu O et selon le cycle thermique ci-dessous :

4

| Température | Temps (en heure) |
|---|---|
| 800° C | 1,5 |
| 983° C | 1 |
| 900° C | 2 |
| 800° C | 1 |

On refroidit comme dans l'exemple 1. On obtient un produit de formule $YBa_2Cu_3O_{7-\delta}$ de densité 5,97 et présentent une résistance nulle au-dessous de ou à 91K.

**Revendications**

1. Matériau céramique supraconducteur de formule

$LnBa_{2-x}Cu_{3-x}O_{7-7/3x-\delta}$

dans laquelle

$0,5 \leq x \leq 1,2$

$0 \leq \delta \leq 0,5$

Ln représentant au moins un élément choisi parmi les lanthanides et l'yttrium.

2. Matériau selon la revendication 1, pour lequel $0,5 \leq x \leq 1$.

3. Matériau selon la revendication 1 ou 2 caractérisé en ce qu'il présente une densité d'au moins 5, notamment d'au moins 5,9.

4. Matériau selon l'une des revendications précédentes caractérisé en ce que Ln est l'yttrium et en ce qu'il présente une résistance nulle à une température d'au plus 92 ± 3 K.

5. Matériau céramique supraconducteur de formule

$LnBa_{2-x}Cu_{3-x}O_{7-7/3x-\delta}$

dans laquelle

$0 \leq x \leq 0,5$

$0 \leq \delta \leq 0,5$

Ln représentant au moins un élément choisi parmi les lanthanides et l'yttrium; de densité d'au moins 5,90 et présentant une résistance nulle à une température d'au plus 92 ± 1K.

6. Matériau selon l'une des revendications précédentes caractérisé en ce qu'il se présente sous une structure de grains de forme sensiblement sphérique.

7. Procédé de préparation du matériau selon l'une des revendications précédentes caractérisé en ce qu'il comprend un frittage d'un mélange de phases ou compositions de nature et dans les proportions suivantes :

n Ba Cu $O_2$,

1 $Ln_2$ Ba Cu $O_5$,

2 Cu O

avec comme conditions $0,6 \leq n \leq 3$.

8. Procédé selon la revendication 7, caractérisé en ce qu'on effectue le frittage à une température comprise entre 930 et 990° C.

9. Procédé selon l'une des revendications 7 ou 8 caractérisé en ce qu'il est mis en oeuvre sous oxygène, plus particulièrement sous oxygène humide.

10. Précurseur de matériau céramique caractérisée en ce qu'il est à base des phases ou compositions suivantes et dans les proportions indiquées

m Ba Cu $O_2$,

1 $Ln_2$ Ba Cu $O_5$,

2 Cu O

avec comme condition $0,6 \leq m \leq 3$.

Ln représentant un élément choisi parmi les lanthanides et l'yttrium.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X | EP-A-282199 (UNIVERSITY OF TOKYO) <br> * revendication 1 * <br> --- | 1-2 | C04B35/00 <br> H01L39/14 <br> H01L39/24 |
| X,P | EP-A-316844 (BAYER AG) <br> * revendications 1, 2 *Examples 1,2 | 1-5 | |
| A | --- | 8 | |
| Y,P | EP-A-319807 (SUMITOMO ELECTRIC INDUSTRIES LTD) <br> * revendications 11-13 * | 7-10 | |
| A | <br><br> --- | 8 | |
| Y | DE-A-3817319 (HITACHI LTD) <br> * revendications 1-9; figure 1 *exemple 1 <br> --- | 7-10 | |
| T | JOURNAL OF LOW TEMPERATURE PHYSICS. <br> vol. 73, no. 3-4, 1988, RESS, NEW YORK US <br> pages 241 - 254; D.Eckert et al.: <br> "Low-Temperature Specific Heat of <br> YBa2Cu3O7,YBa2Cu3O6,Y2BaCuO5,YBa3Cu2O7,BaCuO2 <br> and CuO" <br> * le document en entier * <br> ----- | | |

DOMAINES TECHNIQUES RECHERCHES (Int. Cl.5 )

C04B
H01L

Le présent rapport a été établi pour toutes les revendications

| Lieu de la recherche | Date d'achèvement de la recherche | Examinateur |
|---|---|---|
| LA HAYE | 18 JUILLET 1990 | HARBRON J.L. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03.82 (P0402)